(19) Europäisches Patentamt
European Patent Office
Office européen des brevets

(11) Publication number: **0 154 524 B1**

(12) **EUROPEAN PATENT SPECIFICATION**

(45) Date of publication of patent specification: **08.11.89**

(51) Int. Cl.$^4$: **H 01 F 41/14**

(21) Application number: **85301400.9**

(22) Date of filing: **28.02.85**

(54) **Process for manufacturing a magnetic bubble memory chip.**

(30) Priority: **03.03.84 JP 39741/84**

(43) Date of publication of application:
**11.09.85 Bulletin 85/37**

(45) Publication of the grant of the patent:
**08.11.89 Bulletin 89/45**

(84) Designated Contracting States:
**DE FR GB NL**

(56) References cited:

**PATENTS ABSTRACTS OF JAPAN, vol. 6, no. 218 (E-139)1096r, 2nd November 1982; & JP - A - 57 122 508 (NIPPON DENKI K.K.) 30-07-1982**

**PATENTS ABSTRACTS OF JAPAN, vol. 6, no. 70 (P-113)948r, 6th May 1982; & JP - A - 57 8986 (NIPPON DENKI K.K.) 28-01-1982**

**PATENTS ABSTRACTS OF JAPAN, vol. 6, no. 182 (E-131)1060r, 18th September 1982; & JP - A - 57 96 516 (FUJITSU K.K.) 15-06-1982**

(73) Proprietor: **FUJITSU LIMITED
1015, Kamikodanaka Nakahara-ku
Kawasaki-shi Kanagawa 211 (JP)**

(72) Inventor: **Majima, Teiji
F-201, 882-1, Tsurumaki
Hatano-shi Kanagawa 257 (JP)**

(74) Representative: **Rackham, Stephen Neil et al
GILL JENNINGS & EVERY 53-64 Chancery Lane
London WC2A 1HN (GB)**

(56) References cited:
**PATENTS ABSTRACTS OF JAPAN, vol. 6, no. 164 (E-127)1042r, 27th August 1982; & JP - A - 57 83 014 (HITACHI EISAKUSHO K.K.) 24-05-1982**

**Majima et al., IEEE TRANSACTIONS ON MAGNETICS, Vol. MAG-20 No. 5, September 84, pages 1066-1071**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**EP 0 154 524 B1**

## Description

The present invention relates to a process for manufacturing a magnetic bubble memory chip, and more particularly, to a process for manufacturing a dual spacing type magnetic bubble memory chip having a thin bubble film, on which a first area is provided with minor loop transmission lines for memorizing bubble information and a second area is provided with major transmission lines for recording or reading out the bubble information with respect to the minor loop transmission lines.

At present such a process includes the steps of forming a first insulative layer on the thin bubble film over the first and second areas; forming on the first insulative layer conductive patterns for controlling function gates; coating a second insulative layer of resin over the first insulative layer and the conductive patterns for controlling function gates, and thermosetting the coated second insulative layer; etching part of the second resin insulative layer, which exists in the first area; and, forming minor and major loop transmission lines. In the etching step only part of the depth of the second insulative layer is removed to leave a spacer between the thin bubble film and the transmission lines. During etching of the second insulative layer a difference in the depth of etching of around ±5% can take place between chips in any one batch. Also the condition of an etched surface is often rough which also affects the spacing of the thin magnetic bubble film and the transmission lines. One example of such a process and a chip formed by such a process is disclosed in the paper by the present inventor et al. published at pages 1066-1071 of IEEE Transactions on Magnetics, Vol. MAG-20. No. 5, September 1984.

Recent developments in the design of magnetic bubble memory chips have led to a demand that the bubble information accommodating sections of these chips, comprising the minor loop transmission lines, be made more and more compact to enable a higher density installation of these devices. For instance, in a 4 megabit chip the pattern periods should be 4 µm. On the other hand, in the function sections, such as swap gates, replicate gates, and generators, and major transmission lines (major lines) for recording or reading out the bubble information accommodated in the minor loop transmission line organization, relatively large patterns, such as 16 µm periods, are used to enable a higher degree of positioning accuracy during the manufacturing process of the bubble memory chip. However, where different size transmission patterns are used in a single memory chip, as mentioned above, it has been found that problems in their characteristics occur due to differences in the driving forces. These differences are primarily caused by differences in the spacing between the transmission lines and the thin magnetic bubble film.

According to this invention which is set out in claim 1 in such a process for the manufacture of a magnetic bubble memory chip, the entire depth of the second resin layer and the first insulating layer are removed during the etching step in the first area and the process includes the additional step of forming a third insulative layer over the whole surface including the first and second areas, after the etching step and before the formation of the minor loop transmission lines.

An advantage of the present invention is that there is less variation in the thickness of the spacer and its surface is smooth, thus, providing stable characteristics for the resulting chips.

A particular example of a method in accordance with this invention will now be described and contrasted with the prior art with reference to the accompanying drawings; in which:-

Figure 1 is a cross section of a conventional magnetic bubble memory chip;

Figure 2 is a cross-section of a conventional bubble memory chip at one step in its production;

Figure 3 is a graph illustrating the relationship between the thickness of a spacer in a magnetic bubble memory chip and the bias margin characteristics of the chip;

Figures 4A to 4F are a series of cross-sections through a magnetic bubble memory chip illustrating the process for manufacturing it in accordance with the present invention;

Figure 5 is a plan of a magnetic bubble memory chip manufactured in accordance with the present invention;

Figure 6 is a plan of the minor loop organization and areas adjacent to its gates;

Figure 7 and 8 are plans of the shapes of soft magnetic patterns used in the first and second areas respectively.

Figure 1 illustrates a cross-section of a magnetic bubble memory chip having a dual spacing layer structure manufactured in accordance with a prior art technique, and Figure 2 illustrates an enlarged cross-section of the bubble memory chip of Figure 1 during the manufacturing process. According to the known art, a layer of $SiO_2$ 2 is formed on a garnet film 1 by sputtering and gold (Au) conductive patterns 3 for controlling function gates are formed thereon. In order to level the steps of the conductive pattern 3, a high temperature tolerant resin 4, such as polyladderorganosiloxane (PLOS), is coated thereon and thermoset, and then only the PLOS layer 4 in an area 5 of the chip corresponding to the small-sized transmission patterns for the information accommodating section is etched, with a plasma etching agent including $CF_4$ etchant gas. Permalloy patterns 6 for the transmission patterns are then formed on the etched region.

The above-mentioned prior art method has several problems. First is the unevenness of the rate of etching in each batch when manufacturing the magnetic bubble memory chips. Conventionally, a plannar plate type etching machine is generally used for etching such a high temperature tolerant resin 4, and although this type of etching machine is superior to a cylindrical type etching machine in etching evenness, usually there is still a variation in the rate of etching of within ±5% per one batch. For instance, if the film thickness of the high temperature tolerant resin layer 4 is 3800 Å 10 Å = 1nm and the thickness is to be reduced by etching by 3000 Å, to obtain a spacer having a thickness of 1300 Å including the $SiO_2$ layer 2 of 500 Å, a variation of etching within ±150 Å will occur per one batch when thickness of the high temperature tolerant resin is reduced by 3000 Å. In addition, when variation between the batches are taken into account, there may be a variation of at least ±300 Å. Such a large variation of ±300 Å will cause a serious problem, i.e. degradation of performance of the bubble memory chip, since 1300 Å is the most favourable thickness for a spacer, as will be described hereinafter.

Second is when an uneven face 7 having a thickness of 200 Å to 300 Å is formed on the etched surface, as seen from Figure 2, the permalloy film formed thereon may have a local high spot Hc, which will affect the characteristics of the bubble memory.

Figure 3 shows the relationship between the thickness of the spacer and the bubble propagation performance when using a soft magnetic pattern having 4 µm pattern periods. As can be seen in the figure, a thickness of 1300 Å ensures the most favourable relationship.

Figures 4A to 4F sequentially illustrate the respective steps in a process of manufacturing a magnetic bubble memory chip according to the present invention. In Figures 4A to 4F, reference numeral 10 denotes a thin garnet film of a magnetic bubble; 11, a first insulative layer; 12, a conductive pattern for controlling function gates; 13, a second insulative layer; 14, a first area; 15, a second area; 16, a photoresist layer; 17, a third insulative layer; and 18 and 18′, soft magnetic patterns for bubble transmission.

An embodiment of a process for manufacturing a magnetic bubble memory chip according to the present invention will now be described with reference to Figures 4A to 4F.

In a first step, as shown in Figure 4A, a first insulative layer 11 is formed by sputtering $SiO_2$ to a 500 Å thickness on a magnetic bubble thin film 10 formed on a substrate.

In a second step, as shown in Figure 4B, a function gate controlling conductor consisting of Au, at a thickness about 3500 Å, is formed on the first insulative laver 11 by vapour deposition, and then a function gate controlling conductive pattern 12 is formed by sputtering with a photolithographic method. In this case, TaMo having a thickness 100 Å to 150 Å also can be used to improve the adhesiveness of the Au conductor 12 to the $SiO_2$ insulative layer 11.

In a third step, as shown in Figure 4C, a polyladderorganosiloxane resin (PLOS) having a thickness of 2600 Å, is coated over the whole surface and thermoset to form a second insulative layer 13.

In a fourth step, as shown in Figure 4D, the second area 15 of this chip is covered with a resist 16. On the other hand, in the first area 14 of this chip which will serve as an information accommodating section, the first and second insulative layers 11 and 13 comprising $SiO_2$ and PLOS resin, respectively, are plasma etched with an etching agent including $CF_4$ etchant gas in a plannar plate type dry etching machine, to expose the surface of the thin film 10 in the first area 14 of the magnetic bubble memory chip. In this case, both the first and second insulative layers of $SiO_2$ and PLOS resin can be etched with the same etchant, since a main component of PLOS is Si.

In a fifth step, as shown in Figure 4E, a third insulative layer 17 of $SiO_2$, having a thickness of 1300 Å, is formed by sputtering over the first 14 and second 15 areas. As seen from Figure 3, the thickness of the insulative layer 17 is favourably 1200 Å to 1500 Å, most preferably 1300 Å.

At the sixth and final step, as shown in Figure 4F, after a soft magnetic material, such as permalloy, is formed by vapour deposition on the third insulative layer 17, soft magnetic patterns 18 and 18′ for bubble transmission, having different pattern periods, are formed thereon by photolithography or ion-etching. In this case, the soft magnetic pattern 18 constitutes transmission lines in the minor-loop organization in the first area 14 and the pattern period thereof is, for example, 4 µm to 6 µm. On the other hand, the soft magnetic pattern 18′ constitutes major transmission lines and a pattern for connecting the major transmission lines to the minor-loop organization, and the pattern period thereof is, for example, 8 µm to 16 µm.

According to the illustrated embodiment, since the magnetic bubble thin film 10 is not etched at all with the plasma etching agent using $CF_4$, a slight overetching is effective to prevent any nonuniformity of the etching and variations of the etched layer thickness. Therefore, magnetic bubble memory chips having a stable propagation performance can be obtained.

Figure 5 is a plan view of an embodiment of a magnetic bubble memory chip manufactured in accordance with the present invention. In Figure 5, reference numerals 20-1 to 20-n and 21-1 to 21-n denote minor-loops organization; 22 and 23, boot loops for memorizing information concerning faulty loops in the minor-loop organization; 24, detectors; 25, recording major lines; 26, read out major lines; 27, generators; 28, swap-gates; and 29, replicate-gates.

The embodiment shown in Figure 5 is an odd-and-even number type major-minor organization, in which the first area comprises the minor-loop organization 20-1 to 20-n and 21-1 to 21-n, which serve as an information accommodating section, and the boot loops 22 and 23. The first area 14 uses small soft magnetic patterns 18 (Figure 4F) having 4 µm periods and the thickness of the spacer thereof is 1300 Å, as seen from Figure 4F.

The area other than the first area 14 is the second area, comprising, for instance, the generators 27, the recording major lines 25, the read out major lines 26, the swap-gates 28, the replicate gates 29, the detectors 24, and some small portions of the minor loop organization adjacent to the gates. The second area is constituted by soft magnetic patterns of 8 µm to 16 µm periods and the thickness of the spacer thereof is 4400 Å, as seen from Figure 4F.

Figure 6 is a plan view of the minor-loop organization and the areas adjacent to the gates thereof, in which reference numeral 30 denotes a minor-loop organization; 25, recording major lines; 26, read out major lines; 28, swap-gates; and 29, replicate gates. In Figure 6, the area illustrated by hatching in the minor loop organization 30 is the first area. On the other hand, the area of a few bits adjacent to the gates using large soft magnetic patterns 35 for connecting is included in the second area. Also, as will be understood from Figure 6, the boundary portions between the first and second areas are defined by bubble transmission gaps between adjacent patterns of the respective areas.

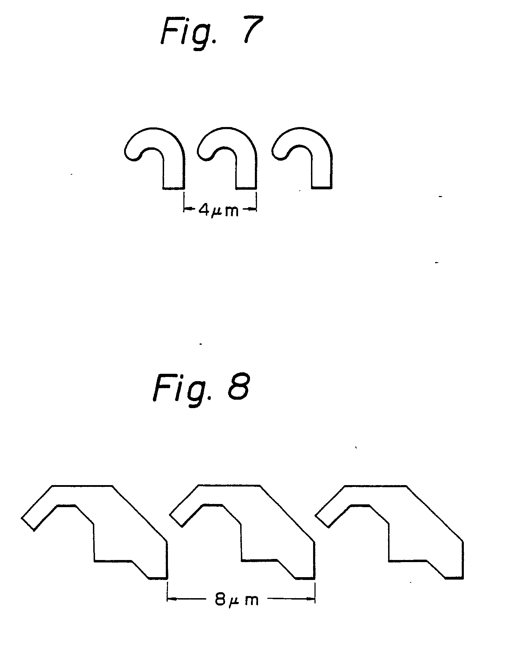

Figures 7 and 8 illustrate soft magnetic patterns used for the transmission lines in the minor loop organization 30 (Figure 6) in the first area, and for the patterns 35 (Figure 6) in the second area, respectively. The pattern illustrated in either Figure 7 or 8 is a so-called "Wide Gap" pattern, which has more advantages in size and in the possibility of high density loading than the half disk pattern or asymmetrical chevron pattern conventionally used in the prior art, since the gap spacing of the former is larger than that of the latter.

As discussed hereinbefore in detail, a method for manufacturing a magnetic bubble memory chip according to the present invention is particularly advantageously adopted when manufacturing a dual-spacing layer structure or dual spacing type bubble chip consisting of thin and thick layers. Consequently, according to the present invention, when the thin layer is formed, the unevenness of etching and variations in thickness thereof are prevented, so that magnetic bubble memory chips having stable bubble propagation performance and characteristics with less variations can be obtained.

**Claims**

1. A process for manufacturing a magnetic bubble memory chip having a thin bubble film (10), in which a first area (14) is to be provided with minor loop transmission lines (18) for at least memorizing bubble information and a second area (15) is to be provided with major transmission lines (18) for recording or reading out bubble information with respect to the minor loop transmission lines (18), the process including the steps of:

forming a first insulative layer (11) on the thin bubble film (19) over the first (14) and second (15) areas;

forming on the first insulative layer (11) conductive patterns (12) for controlling function gates;

coating a second insulative layer (13) of resin over the first insulative layer (11) and the conductive patterns (12) for controlling function gates, and thermosetting the coated second insulative layer (13);

etching part of the second resin insulative layer (13), which exists in the first area (14); and,

forming minor and major loop transmission lines (18), removing the entire depth of the second resin layer (13) and the first insulating layer (11) during the etching step in the first area (14) and

forming a third insulative layer (17) over the whole surface including the first (14) and second (15) areas, after the etching step and before the formation of the minor loop transmission lines (18).

2. A process according to claim 1, wherein a bubble transmission pattern in the minor loop transmission lines (18) has a pattern period which is smaller than that of a bubble transmission pattern in the major transmission lines (18').

3. A process according to claim 1 or 2, wherein the third insulative layer (17) is $SiO_2$ and has a thickness in a range from 120 nm to 150 nm.

4. A process according to claim 3, wherein the thickness of the $SiO_2$ layer is substantially 130 nm.

5. A process according to any one of the preceding claims, wherein the bubble transmission patterns (18, 18') in the first (14) and second (15) areas are formed with soft magnetic patterns, and the soft magnetic pattern (18) in the first area (14) has a pattern period of 4 µm to 6 µm and the soft magnetic pattern (18') in the second area (15) has a pattern period of not less than 8 µm.

6. A method according to any one of the preceding claims, wherein the first area (14) includes a boot loop (22, 23) for memorizing information about faulty loops in the minor loop transmission lines (20-n).

7. A method according to any one of the preceding claims, wherein the soft magnetic patterns (30) in at least the first area (14) are wide gap patterns.

**Patentansprüche**

1. Verfahren zur Herstellung eines Magnetblasenspeicherchip mit einem dünnen Blasenfilm (10), bei dem ein erster Bereich (14) mit Nebenkreisübertragungsleitungen (18) versehen werden soll, um wenigstens Blaseninformation zu speichern, und ein zweiter Bereich (15) mit Hauptübertragungsleitungen (18) versehen werden soll, um Blaseninformation bezüglich der Nebenkreis-Übertragungsleitungen (18) aufzuzeichnenoder auszulesen, welches Verfahren die folgenden Schritte umfaßt:

Bilden einer ersten isolierenden Schicht (11) auf dem dünnen Blasenfilm (19) über den ersten (14) und zweiten (15) Bereichen;

Bilden von leitenden Mustern (12), auf der ersten isolierenden Schicht (11), zum Steuern der Funktionsgates;

Überziehen einer zweiten isolierenden Schicht (13) aus Harz über der ersten isolierenden Schicht (11) und den leitenden Mustern (12) zum Steuern der Funktionsgates, und Wärmehärten der überzogenen zweiten isolierenden Schicht (13);

Ätzen eines Teiles der zweiten Harz-Isolationsschicht (13), welche in dem ersten Bereich (14) existiert; und

Bilden von Neben- und Hauptkreis-Übertragungsleitungen (18);

Entfernen der gesamten Tiefe der zweiten Harzschicht (13) und der ersten isolierenden Schicht (11) während des Ätzschrittes in dem ersten Bereich (14),

Bilden einer dritten isolierenden Schicht (17) über der gesamten Oberfläche einschließlich der ersten (14) und zweiten (15) Bereiche, nach dem Ätzschritt und vor der Bildung der Nebenkreis-Übertragungsleitungen (18).

2. Verfahren nach Anspruch 1, bei dem ein Blasenübertragungsmuster in den Nebenkreis-Übertragungsleitungen (18) eine Musterperiode hat, die kleiner als diejenige eines Blasenübertragungsmusters in den Hauptübertragungsleitungen (18') ist.

3. Verfahren nach Anspruch 1 oder 2, bei dem die dritte isolierende Schicht (17) $SiO_2$ ist und eine Dicke im Bereich von 120 nm bis 150 nm hat.

4. Verfahren nach Anspruch 3, bei dem die Dicke der $SiO_2$-Schicht im wesentlichen 130 nm beträgt.

5. Verfahren nach einem der vorhergehenden Ansprüche, bei dem die Blasenübertragungsmuster (18, 18') in den ersten (14) und zweiten (15) Bereichen mit weichen Magnetmustern gebildet werden, und das weiche Magnetmuster (18) in dem ersten Bereich (14) eine Musterperiode von 4 µm bis 6 µm und das weiche magnetische Muster (18') in dem zweiten Bereich (15) eine Musterperiode von nicht weniger als 8 µm hat.

6. Verfahren nach einem der vorhergehenden Ansprüche, bei dem der erste Bereich (14) eine boot-Kreis (22, 23) zum Speichern von Information über fehlerhafte Kreise in den Nebenkreis-Übertragungsleitungen (20-n) umfaßt.

7. Verfahren nach einem der vorher ehe bei dem die weichen magnetischen Muster (30) in wenigstens dem ersten Bereich (14) Muster mit breiten Spalten sind.

**Revendications**

1. Procédé de fabrication d'une puce mémoire à bulles magnétiques comportant un film mince à bulles (10), dans lequel une première zone (14) doit être pouvue de fils de transmission en boucles mineures (18) pour au moins mémoriser des informations de bulles et une deuxième zone (15) doit être pourvue de fils de transmission majeurs (18) pour enregistrer ou lire des informations de bulles par rapport aux fils de transmission en boucles mineures (18), le procédé consistant à:

former une première couche isolante (11) sur le film mince à bulles (10) sur la première (14) et la deuxième zone (15);

former sur la première couche isolante (11) des dessins de matériau conducteur (12) pour commander des portes de fonction;

déposer une deuxième couche isolante (13) de résine sur la première couche isolante (11) et les dessins de matériau conducteur (12) pour commander les portes de fonction, et thermodurcir la deuxième couche isolante déposée (13);

attaquer une partie de la deuxième couche isolante de résine (13), qui se trouve dans la première zone (14); et à,

former des fils de transmission en boucles mineures et majeures (18), retirer toute la profondeur de la deuxième couche de résine (13) et de la première couche isolante (11) pendant l'opération d'attaque dans la première zone (14) et

former une troisième couche isolante (17) sur toute la surface incluant la première (14) et la deuxième zone (15), après l'opération d'attaque et avant la formation des fils de transmission en boucles mineures (18).

2. Procédé selon la revendication 1, dans lequel un dessin de transmission de bulles dans les fils de transmission en boucles mineures (18) a une période de dessin qui est inférieure à celle d'un dessin de transmission de bulles dans les fils de transmission majeurs (18').

3. Procédé selon l'une quelconque des revendications 1 et 2, dans lequel la troisième couche isolante (17) est constituée de $SiO_2$ et a une épaisseur comprise entre 120 nanomètres et 150 nanomètres.

4. Procédé selon la revendication 3, dans lequel l'épaisseur de la couche de $SiO_2$ est effectivement égale à 130 nanomètres.

5. Procédé selon l'une quelconque des revendications 1 à 4, dans lequel les dessins de transmission de bulles (18, 18') dans la première (14) et la deuxième zone (15) sont formés avec des dessins de matériau faiblement magnétique, et le dessin de matériau faiblement magnétique (18) dans la première zone (14) a une période de dessin comprise entre 4 µm et 6 µm et le dessin de matériau faiblement magnétique (18') dans la deuxième zone (15) a une période de dessin aumoins égale à 8 µm.

6. Procédé selon l'une quelconque des revendications 1 à 5, dans lequel la première zone (14) comprend une boucle d'amorçage (22, 23) pour mémoriser des informations sur des boucles défectueuses dans les fils de transmission en boucles mineures (20-n).

7. Procédé selon l'une quelconque des revendications 1 à 6, dans lequel les dessins de matériau faiblement magnétique (30) dans au moins la première zone (14) sont des dessins à large espace.

Fig. 1 (prior art)

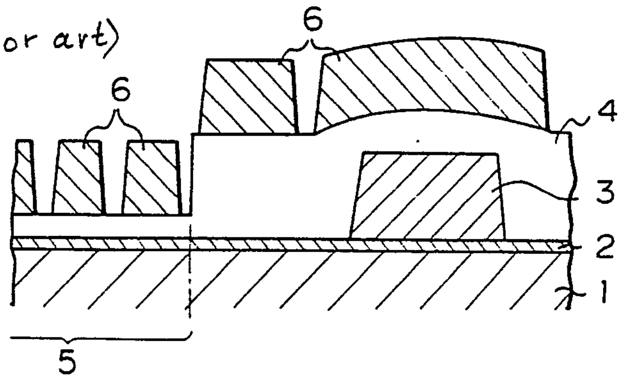


Fig. 2 (prior art)

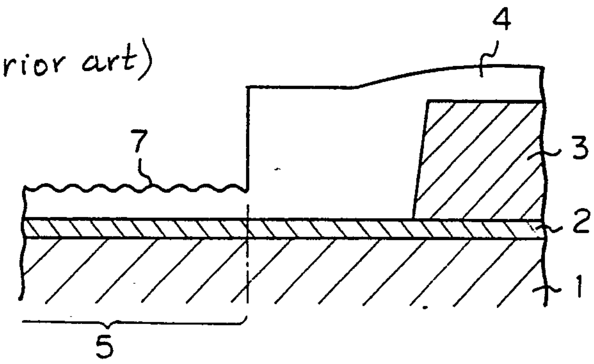


Fig. 3

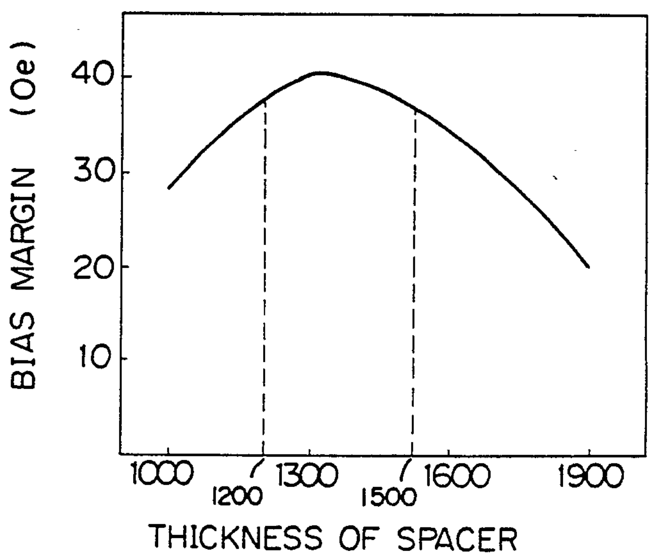

Fig. 4A

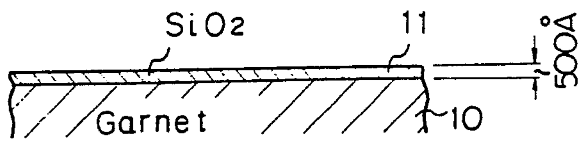


Fig. 4B

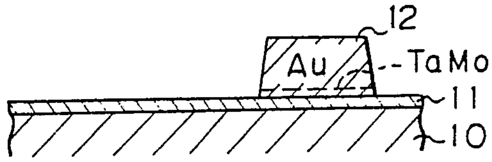


Fig. 4C

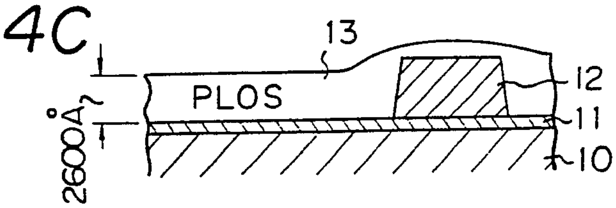


Fig. 4D

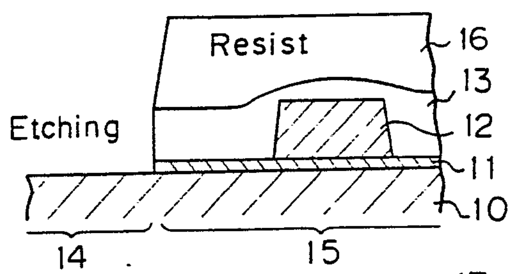


Fig. 4E

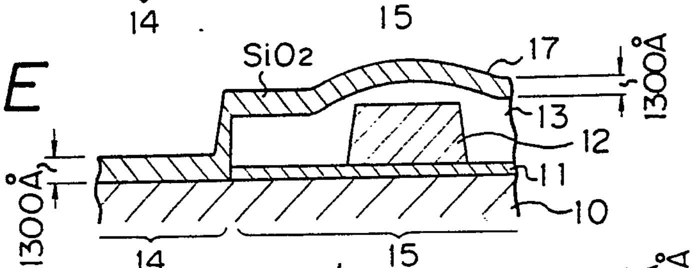


Fig. 4F

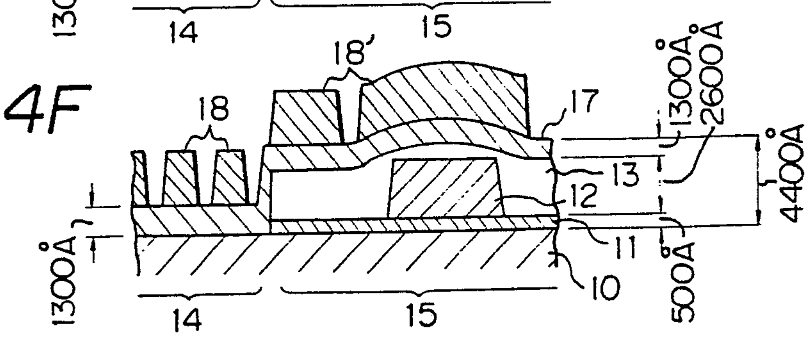

Fig. 5

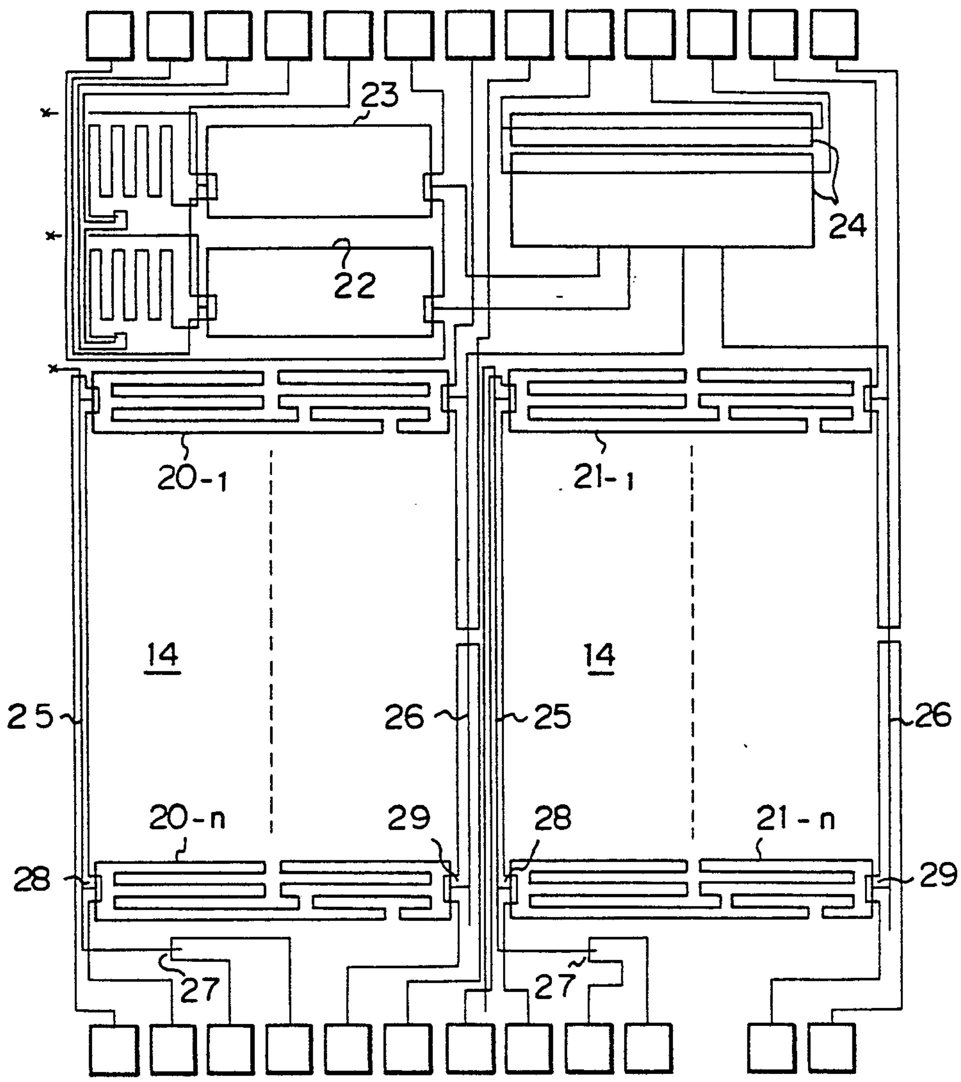

Fig. 6

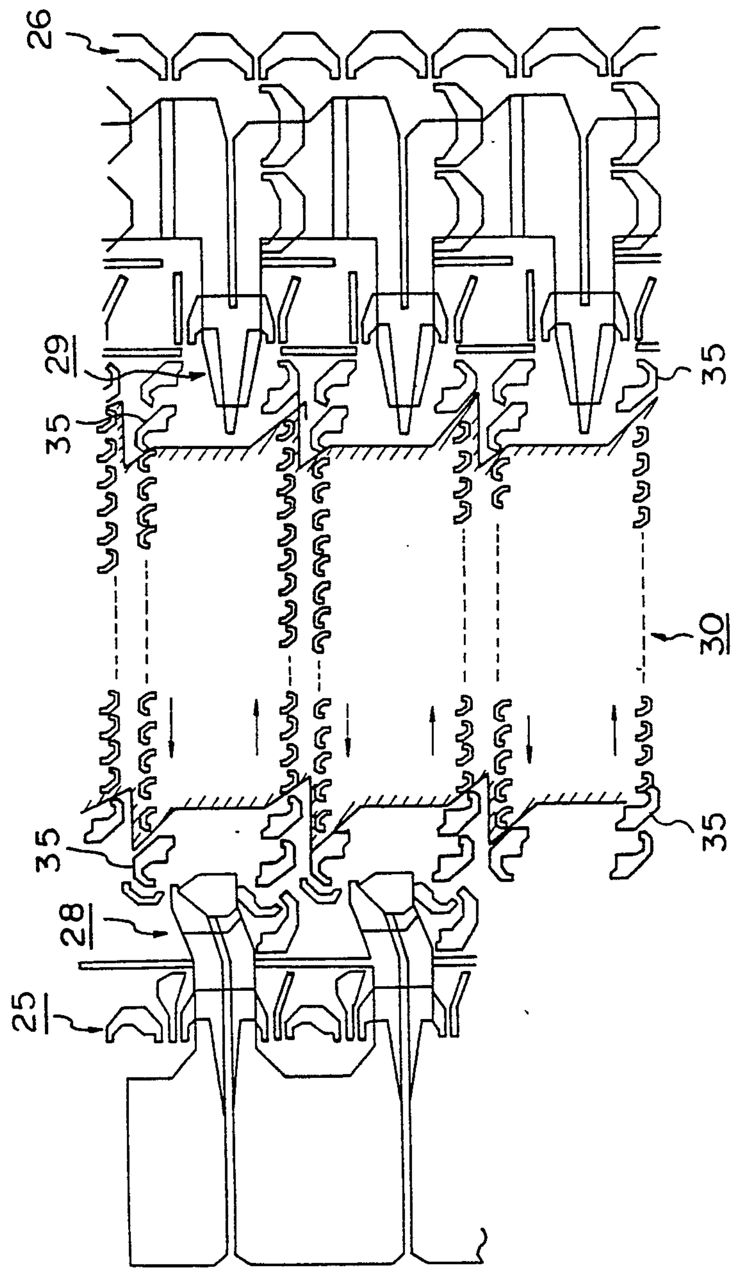

Fig. 7

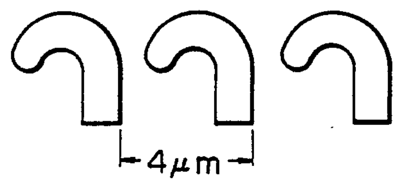


Fig. 8